# FASCICULE DE BREVET EUROPEEN

(11) **EP 4 248 127 B1**
(45) Date de publication et mention de la délivrance du brevet: **04.12.2024**
(21) Numéro de dépôt: 21786920.5
(22) Date de dépôt: 05.10.2021
(51) Int. Cl.: F21S 2/00, F21V 1/12, F21V 3/02, F21V 21/002

(54) **DISPOSITIF D'ECLAIRAGE**
BELEUCHTUNGSEINRICHTUNG
LIGHTING DEVICE

(30) Priorité: 23.11.2020 FR 2012025
(43) Date de publication de la demande: 27.09.2023
(73) Titulaire: Airstar SAS, 38190 Le Champ-Pres-Froges (FR)
(72) Inventeur: EMBERGER, Simon, 38190 LE CHAMP-PRES-FROGES (FR); DUPUIS, Adrien, 38190 LE CHAMP-PRES-FROGES (FR); WATELET, Florian, 38190 LE CHAMP-PRES-FROGES (FR); FRANCOIS, Sébastien, 38190 LE CHAMP-PRES-FROGES (FR)
(74) Mandataire: Cabinet Beaumont
(86) Numéro de dépôt international: PCT/EP2021/077336
(87) Numéro de publication internationale: WO 2022/106108

(56) Documents cités:
- EP-A1- 3 321 568
- US-A1- 2012 182 739
- US-A1- 2019 341 718

## Description

La présente demande est basée sur, et revendique la priorité de, la demande de brevet français FR2012025 déposée le 23 novembre 2020 et ayant pour titre "Dispositif d'éclairage".

### Domaine technique

La présente description concerne de façon générale les dispositifs d'éclairage, et vise plus particulièrement un dispositif d'éclairage modulaire à diodes électroluminescentes (LED). La présente description concerne par ailleurs le domaine des ballons éclairants à enveloppe gonflable, et, plus particulièrement, le contrôle du gonflage de l'enveloppe dans de tels ballons.

### Technique antérieure

De nombreux dispositifs d'éclairage à LED ont déjà été proposés. Il serait toutefois souhaitable de pouvoir disposer d'un dispositif d'éclairage à LED palliant tout ou partie des inconvénients des dispositifs connus. En particulier, il serait souhaitable de pouvoir disposer d'un dispositif d'éclairage à LED plus fiable, plus simple à assembler, plus simple à dépanner, et/ou présentant des fonctionnalités supplémentaires par rapport aux dispositifs connus. US 2019/341718 A1 divulgue un dispositif d'éclairage à LED fiable et simple à assembler.

Il serait par ailleurs souhaitable de pouvoir améliorer le contrôle du gonflage de l'enveloppe dans des dispositifs d'éclairage de type ballons gonflables.

### Résumé de l'invention

Pour cela, un mode de réalisation prévoit un dispositif d'éclairage comportant :
- une structure de support électriquement conductrice ; et
- une pluralité de modules d'éclairage élémentaires fixés sur la structure de support, chaque module élémentaire comportant une carte de circuit imprimé et, montés sur la carte de circuit imprimé, un ensemble de LED et un circuit électronique d'alimentation et de commande de l'ensemble de LED,
dans lequel, dans chaque module élémentaire, la carte de circuit imprimé du module comprend au moins une borne de référence, les bornes de référence des cartes de circuit imprimé des différents modules élémentaires étant connectées électriquement les unes aux autres par l'intermédiaire de la structure de support.

Selon un mode de réalisation, chaque module élémentaire comprend un support de fixation du module sur la structure de support.

Selon un mode de réalisation, dans chaque module élémentaire le support de fixation du module comprend une pièce électriquement conductrice connectant électriquement une borne de référence de la carte de circuit imprimé du module à la structure de support.

Selon un mode de réalisation, la pièce électriquement conductrice comprend une tige conductrice munie à ses extrémités de pattes conductrices comportant chacune une ouverture traversée par une tige conductrice de la structure de support.

Selon un mode de réalisation, chaque module élémentaire comprend en outre un carter de protection transparent ou translucide placé en vis-à-vis de la carte de circuit imprimé du module, le carter de protection étant fixé sur ledit support de fixation du module.

Selon un mode de réalisation, les modules élémentaires sont agencés selon un ou plusieurs étages en forme de prisme, les modules étant disposés sur les faces latérales du prisme.

Selon un mode de réalisation, les modules élémentaires sont disposés selon un agencement planaire.

Selon l'invention, les modules élémentaires sont agencés selon une pluralité de colonnes comprenant chacune plusieurs modules élémentaires, chaque module comprenant deux connecteurs d'alimentation et de contrôle, et les modules élémentaires d'une même colonne sont connectés en chaine via leurs connecteurs d'alimentation et de contrôle respectifs.

Selon un mode de réalisation, le dispositif comprend en outre un circuit électronique d'alimentation et de contrôle connecté à une extrémité de chaque colonne.

Selon un mode de réalisation, le circuit électronique d'alimentation et de contrôle est configuré pour mettre en oeuvre un procédé de diagnostic comprenant une étape de mesure d'une grandeur représentative d'un courant consommé par une colonne et/ou d'une tension aux bornes d'une colonne de modules élémentaires.

Selon un mode de réalisation, le circuit électronique d'alimentation et de contrôle est configuré pour mettre en oeuvre un procédé de diagnostic comprenant les étapes suivantes :
a) commander un module élémentaire d'une colonne à l'état allumé et mesurer une valeur représentative du courant circulant dans la colonne;
b) commander ledit module élémentaire de ladite colonne à l'état éteint et mesurer une valeur représentative du courant circulant dans la colonne ; et
c) comparer la différence entre la valeur mesurée à l'étape a) et la valeur mesurée à l'étape b) à une valeur nominale de référence et, si l'écart entre ladite différence et ladite valeur nominale de référence excède une marge déterminée, en déduire que ledit module élémentaire est défaillant.

Selon un mode de réalisation, le dispositif comprend une enveloppe diffusante entourant la structure de support et les modules élémentaires.

Selon un mode de réalisation, l'enveloppe diffusante est une enveloppe gonflable.

Un autre mode de réalisation prévoit un dispositif d'éclairage comportant :
- une structure éclairante ;
- une enveloppe gonflable entourant la structure éclairante ;
- un ventilateur de gonflage adapté à assurer le gonflage de l'enveloppe ; et
- un circuit électronique de contrôle configuré pour, lors d'une phase de gonflage de l'enveloppe, surveiller la vitesse de rotation du ventilateur de gonflage, détecter une augmentation de ladite vitesse de rotation correspondant à une entrée en cavitation du ventilateur à la fin de la phase de gonflage, et, lorsque ladite augmentation est détectée, réduire la valeur d'une consigne de puissance appliquée au ventilateur.

Selon un mode de réalisation, le ventilateur de gonflage comprend un capteur de vitesse de rotation relié au circuit électronique de contrôle.

Selon un mode de réalisation, le circuit électronique de contrôle est configuré pour, pendant la phase de gonflage, commander le ventilateur de gonflage à sa puissance maximale.

Selon un mode de réalisation, le circuit de contrôle est en outre configuré pour mesurer le temps écoulé depuis le début de la phase de gonflage, et, si le temps écoulé atteint, avant la détection de l'entrée en cavitation du ventilateur, un seuil prédéfini correspondant à une durée nominale maximale de gonflage, émettre un signal d'alerte de défaut d'étanchéité de l'enveloppe gonflable à l'attention d'un utilisateur.

Selon un mode de réalisation, pour l'émission du signal d'alerte, le circuit de contrôle commande le clignotement d'au moins une source lumineuse de la structure éclairante selon une séquence prédéterminée, et/ou l'envoi d'un message d'alerte à un terminal distant via un canal de communication filaire ou sans fil.

Selon un mode de réalisation, le circuit électronique de contrôle est en outre configuré pour, pendant ou en dehors de la phase de gonflage :
- appliquer une consigne de puissance au ventilateur de gonflage ;
- déterminer la vitesse de rotation du ventilateur de gonflage, et comparer ladite vitesse de rotation à un seuil prédéfini correspondant à une vitesse de rotation nominale pour ladite consigne de puissance ; et
- si ladite vitesse de rotation est supérieure audit seuil, émettre un signal d'alerte de colmatage d'un filtre d'admission du ventilateur.

Selon un mode de réalisation, la structure éclairante comprend :
- une structure de support ; et
- une pluralité de modules d'éclairage élémentaires fixés sur la structure métallique de support, chaque module élémentaire comportant une carte de circuit imprimé et, montés sur la carte de circuit imprimé, un ensemble de LED et un circuit électronique d'alimentation et de commande de l'ensemble de LED.

Selon un mode de réalisation, dans chaque module élémentaire, la carte de circuit imprimé du module comprend au moins une borne de référence, les bornes de référence des cartes de circuit imprimé des différents modules élémentaires étant connectées électriquement les unes aux autres par l'intermédiaire de la structure de support.

Selon un mode de réalisation, chaque module élémentaire comprend un support de fixation du module sur la structure de support.

Selon un mode de réalisation, dans chaque module élémentaire le support de fixation du module comprend une pièce conductrice connectant électriquement une borne de référence de la carte de circuit imprimé du module à la structure métallique de support.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective partielle d'un exemple d'une structure éclairante d'un dispositif d'éclairage à LED selon un mode de réalisation ;
la figure 2 est une vue en perspective d'un autre exemple d'une structure éclairante d'un dispositif d'éclairage à LED selon un mode de réalisation ;
la figure 3 est une vue en perspective d'un autre exemple d'une structure éclairante d'un dispositif d'éclairage à LED selon un mode de réalisation ;
la figure 4 est une vue en perspective éclatée d'un exemple d'un module d'éclairage élémentaire d'un dispositif d'éclairage à LED selon un mode de réalisation ;
la figure 5 est une vue de face partielle d'un exemple d'un dispositif d'éclairage à LED selon un mode de réalisation ;
la figure 6 est une vue de face schématique d'un exemple d'un ballon d'éclairage à enveloppe gonflable selon un mode de réalisation ;
la figure 7 est un schéma électrique simplifié d'un dispositif d'éclairage à LED selon un mode de réalisation ;
la figure 8 est un schéma électrique plus détaillé d'un exemple de réalisation d'un module d'éclairage élémentaire d'un dispositif d'éclairage à LED selon un mode de réalisation ;
la figure 9 illustre une variante de réalisation du module d'éclairage élémentaire de la figure 8 ;
la figure 10 illustre un exemple de réalisation d'une carte de distribution de puissance d'un dispositif d'éclairage à LED selon un mode de réalisation ;
la figure 11 illustre schématiquement, sous forme de blocs, des étapes d'un exemple d'un procédé de détection de défauts dans un dispositif d'éclairage à LED selon un mode de réalisation ;
la figure 12 illustre plus en détail une étape du procédé de la figure 11 ;
la figure 13 illustre une variante de mise en oeuvre d'une étape du procédé de la figure 11 ; et
la figure 14 illustre schématiquement, sous forme de blocs, un exemple d'un procédé de contrôle du gonflage d'une enveloppe d'un ballon éclairant à enveloppe gonflable selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des LED et des circuits électroniques d'alimentation et de commande des dispositifs décrits n'a pas été détaillée, la réalisation de ces éléments est en effet à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

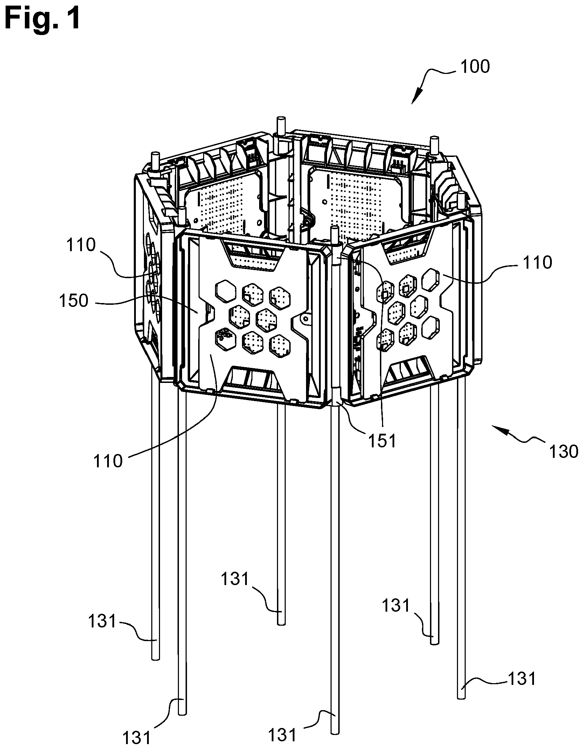

La figure 1 est une vue en perspective partielle d'un exemple d'une structure éclairante 100 d'un dispositif d'éclairage à LED selon un mode de réalisation.

La structure éclairante 100 comprend une pluralité de modules d'éclairage élémentaires 110, identiques ou similaires, fixés sur une même structure de support 130 en un ou plusieurs matériaux électriquement conducteurs, par exemple de métal, du carbone, ou un matériau polymère dopé au carbone.

Dans l'exemple de la figure 1, la structure de support 130 est destinée à recevoir dix-huit modules élémentaires 110 répartis en trois étages superposés de six modules chacun. Par souci de clarté, seuls les six modules élémentaires 110 de l'étage supérieur ont été représentés sur la figure 1.

Dans cet exemple chaque module élémentaire 110 a la forme d'un panneau sensiblement rectangulaire ou carré. Dans chaque étage, les six modules élémentaires 110 de l'étage sont disposés selon un agencement en prisme hexagonal. Plus particulièrement, les six modules élémentaires 110 de l'étage forment respectivement les six faces rectangulaires du prisme hexagonal. Les différents étages sont alignés verticalement selon un même axe central. Plus particulièrement, dans cet exemple, dans chaque étage de la structure éclairante 100, chaque module élémentaire 110 de l'étage est aligné verticalement, par ses bords verticaux, avec un module élémentaire 110 de chaque autre étage

La structure de support 130 de la figure 1 comprend six tiges verticales 131, par exemple identiques ou similaires, régulièrement réparties selon une disposition circulaire (en vue de dessus). Les tiges définissent les arrêtes de la structure prismatique hexagonale. Les tiges 131 sont en un matériau électriquement conducteur, par exemple du métal, du carbone, ou un matériau polymère dopé au carbone.

Chaque module élémentaire 110 comprend un support 150 utilisé pour fixer le module 110 à la structure de support 130. Dans cet exemple, chaque support 150 a une forme générale rectangulaire ou carrée et des dimensions latérales correspondant sensiblement aux dimensions latérales du module 110. Chaque support 150 comprend, du côté d'un bord vertical du module 110, une ou plusieurs bagues de fixation 151, destinées à venir s'enfiler sur l'une des tiges 131 de la structure de support. Dans l'exemple représenté, chaque support 150 comprend deux bagues de fixation 151 disposées respectivement aux deux extrémités d'un même bord vertical du support 150. Lorsqu'un module élémentaire 110 est monté sur la structure de support 130, la ou les bagues de fixation 151 du module sont traversées par une même tige 131 de la structure de support. Le bord vertical du support 150 opposé aux bagues 151 comprend lui, en partie inférieure du module, une ouverture traversée par une tige 131 voisine de la structure de support 130. Plus particulièrement, dans cet exemple, en vue de face depuis l'extérieur de la structure éclairante, dans chaque module élémentaire 110, le support de fixation 150 du module comprend, du côté de son bord droit, deux bagues de fixation 151 disposées respectivement en partie supérieure et en partie inférieure du bord du module, enfilées sur une tige 131 de la structure de support 130, et, du côté de son bord gauche, une ouverture (non visible sur la figure) traversée par une tige 131 voisine. Ainsi, dans cet exemple, dans chaque étage, chaque portion de tige 131 définissant une arrête du prisme hexagonal de l'étage :
- d'une part traverse les bagues de fixation 151 du support de fixation 150 d'un premier module élémentaire 110 de l'étage, situé majoritairement à gauche de ladite tige 131 ; et
- d'autre part traverse une ouverture du support de fixation 150 d'un deuxième module élémentaire 110 de l'étage, situé majoritairement à droite de ladite tige 131.

Cet agencement permet une fixation robuste des modules élémentaires 110 de chaque étage sur un nombre de tiges 131 égal au nombre de modules élémentaires 110 de l'étage. Les modes de réalisation décrits ne se limitent toutefois pas à cet agencement particulier.

Un avantage de la structure éclairante décrite en relation avec la figure 1 est qu'elle peut facilement être déclinée dans de nombreuses autres formes et/ou dimensions à partir des mêmes modules élémentaires de base 110, en adaptant simplement la disposition et/ou le nombre de tiges 131 de la structure de support 130. Ceci permet de couvrir des applications variées en limitant les coûts de conception et de fabrication des dispositifs pour chaque nouvelle application. En particulier, le nombre de modules élémentaires 110 peut être choisi en fonction de la puissance lumineuse totale souhaitée. A titre d'exemple, chaque module élémentaire 110 a une puissance lumineuse d'émission comprise entre 1 et 10000 lumens, par exemple entre 10 et 5000 lumens, par exemple entre 100 et 1000 lumens. La puissance lumineuse d'émission totale du dispositif (somme des puissances émises par les différents modules élémentaires 110) est par exemple comprise entre 50 et 1000000 lumens, par exemple entre 5000 et 500000 lumens.

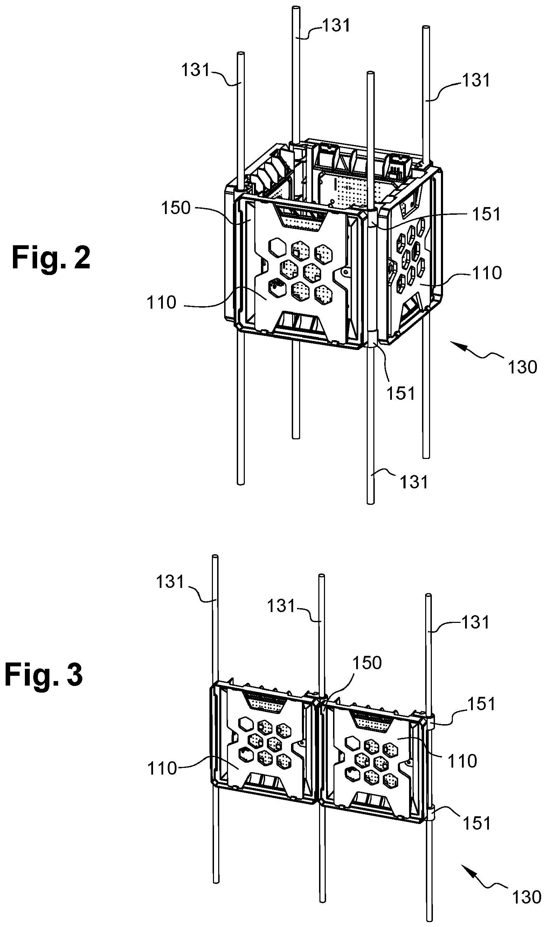

Les figures 2 et 3 illustrent d'autres exemples (non limitatifs) de configurations possibles d'une structure éclairante du type décrit en relation avec la figure 1.

Dans l'exemple de la figure 2, la structure comprend quatre modules élémentaires 110 par étage, disposés respectivement selon les quatre faces latérales d'un prisme à base carrée. La structure de support comprend quatre tiges 131, définissant respectivement les quatre arrêtes du prisme. Dans l'exemple de la figure 2, un seul étage a été représenté. Selon l'application visée, la structure éclairante pourra comprendre plusieurs étages empilés verticalement tel que décrit en relation avec la figure 1.

Dans l'exemple de la figure 3, la structure comprend deux modules élémentaires 110 par étage, alignés linéairement dans un même plan. La structure de support comprend trois tiges 131 alignées linéairement en vue de dessus. Dans l'exemple de la figure 3, un seul étage de deux modules a été représenté. Selon l'application visée, la structure éclairante pourra comprendre plusieurs étages empilés verticalement tel que décrit en relation avec la figure 1 et/ou un nombre de modules élémentaires 110 par étage différent de deux (par exemple un seul module par étage ou plus de deux étages par module).

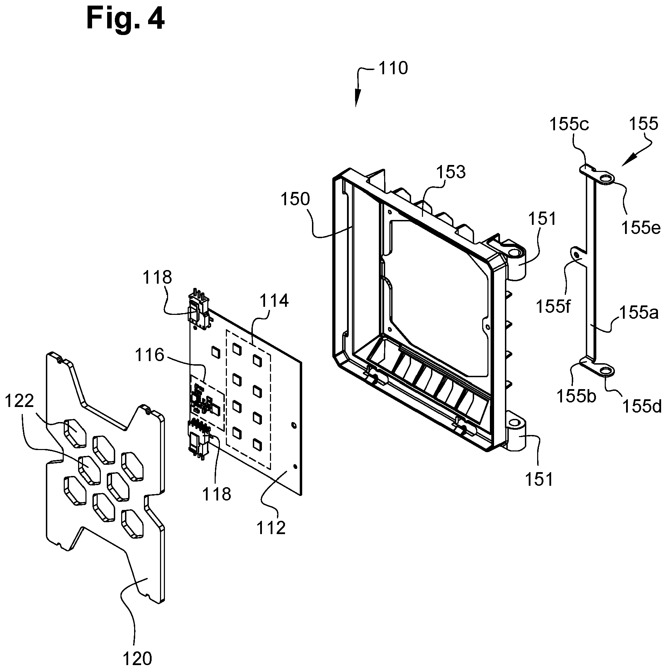

La figure 4 est une vue en perspective éclatée d'un exemple d'un module d'éclairage élémentaire 110 d'une structure éclairante du type décrit en relation avec les figures 1, 2 et 3.

Le module 110 comprend une carte de circuit imprimé 112, sur laquelle sont montés un ensemble 114 d'une ou plusieurs LED (huit LED régulièrement réparties sur la surface de la carte de circuit imprimé dans l'exemple représenté) et un circuit électronique 116 d'alimentation et de commande de l'ensemble de LED. Chaque module 110 comprend sa propre carte de circuit imprimé 112, disjointe de celles des autres modules 110. Ainsi, chaque module 110 constitue un panneau d'éclairage élémentaire indépendant des autres modules. Les dimensions de la carte de circuit imprimé 112 correspondent sensiblement aux dimensions du module 110. A titre d'exemple, la carte de circuit imprimé 112 a une forme générale rectangulaire ou carrée de longueur comprise entre 50 et 250 mm et de largeur comprise entre 50 et 250 mm.

Dans l'exemple représenté, le module 110 comprend en outre, montés sur la carte de circuit imprimé, deux connecteurs 118, par exemple identiques ou similaires, destinés à connecter le module 110 à un dispositif extérieur, par exemple un autre module 110 ou un circuit électronique d'alimentation et de contrôle de la structure éclairante.

Dans l'exemple de la figure 4, les connecteurs 118 sont disposés respectivement du côté du bord supérieur et du côté du bord inférieur du module, au voisinage du bord droit du module. Les modes de réalisation décrits ne se limitent toutefois pas à cet agencement particulier.

Chaque module élémentaire 110 comprend en outre un carter de protection 120 placé en vis-à-vis de la carte de circuit imprimé 112 du module, du côté de la face d'éclairement du module. Le carter 120 peut comprendre une plaque transparente ou translucide, par exemple en verre ou en un matériau polymère, de dimensions sensiblement égales à celles de la carte de circuit imprimé 112, placée parallèlement à la carte de circuit imprimé 112, du côté de la face de la carte de circuit imprimé 112 sur laquelle sont montées les LED 114 du module. A titre de variante le carter de protection 120 peut comporter une plaque opaque comportant une ou plusieurs ouvertures 122 en vis-à-vis de la face de la carte de circuit imprimé 112 sur laquelle sont montées les LED 114 du module, par exemple tel que représenté sur la figure 4.

Le support de fixation 150 permet d'assurer la mise en place et le maintien en position de la carte de circuit imprimé 112 sur la structure de support 130 (figures 1 à 3). Dans cet exemple, le carter de protection 120 est fixé directement sur le support de fixation 150, par exemple par clipsage. Ceci permet de transmettre directement à la structure de support 130 d'éventuels chocs subis par le carter de protection 120, limitant ainsi les efforts subis par la carte de circuit imprimé 112.

Dans cet exemple, le support de fixation 150 comprend un cadre 153, par exemple de forme générale carrée ou rectangulaire et des dimensions latérales correspondant sensiblement aux dimensions latérales du module 110, destiné à recevoir la carte de circuit imprimé 112 et, au-dessus de la carte de circuit imprimé 112, le carter de protection 120. Les bagues de fixation 151 sont disposées du côté d'un bord vertical du cadre 153. Le cadre 153 et les bagues de fixation 151 sont par exemple en un matériau électriquement isolant, par exemple en plastique. A titre d'exemple, le cadre 153 et les bagues de fixation 151 forment un élément monobloc, par exemple réalisé par moulage. Du côté de son bord vertical opposé aux bagues 151, le cadre 153 peut comprendre une ouverture, non visible sur les figures, destinée à être traversées par une tige 131.

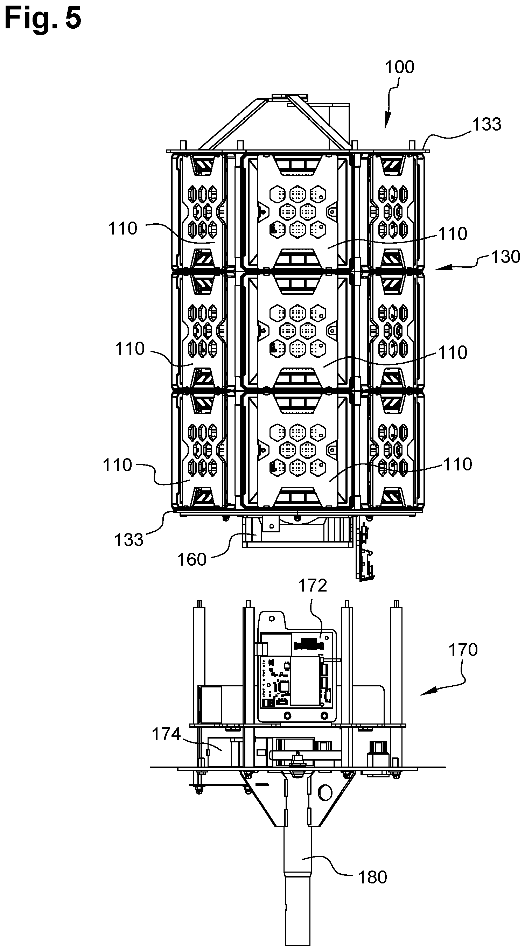

Dans cet exemple, le support de fixation 150 assure en outre une fonction de connexion électrique de bornes ou plages de connexion de référence de la carte de circuit imprimé 112 à la structure de support 130. Les bornes de référence sont destinées à être connectées à un potentiel de référence du dispositif, par exemple la masse ou tout autre potentiel de référence, par exemple un potentiel d'alimentation positif. Pour cela, dans cet exemple, le support 150 comprend une pièce électriquement conductrice 155, par exemple métallique, en contact d'une part avec une borne de connexion de référence (non détaillée sur la figure 4) de la carte de circuit imprimé 112 et d'autre part avec la tige métallique 131 traversant les bagues de fixation 151 du support 150. Ainsi, les bornes de référence des cartes de circuit imprimé 112 des différents modules élémentaires 110 d'une même colonne sont toutes connectées les unes aux autres par l'intermédiaire de la tige métallique 131 traversant les bagues de fixation 151 desdits modules. Les différentes tiges métalliques 131 de la structure de support 130 peuvent être connectées électriquement les unes aux autres par une pièce de liaison, non représentée, de la structure de support 130, en un matériau électriquement conducteur. Ceci permet d'assurer l'équipotentialité des bornes de référence des différents modules 110. A titre d'exemple, la pièce de liaison peut être une platine supérieure et/ou une platine inférieure 133 (visibles sur la figure 5) en un matériau électriquement conducteur. Chaque platine peut comprendre des ouvertures dans lesquelles passent les tiges conductrices 131, ce qui permet d'assurer l'écartement latéral des tiges 131 et la connexion électrique entre les différentes tiges 131.

Dans l'exemple représenté, la pièce électriquement conductrice 155 du support de fixation 150 comprend une tige métallique 155a de longueur sensiblement égale à la hauteur du cadre 153. La tige 155a est munie, à chacune de ses deux extrémités, d'une patte 155b, respectivement 155c. Chacune des pattes 155b et 155c comprend une ouverture traversante 155d, respectivement 155e, destinée à être traversée par la tige conductrice 131 traversant les bagues de fixation 151 du support 150. Ainsi, la tige conductrice 131 vient en contact mécaniquement et électriquement avec la pièce 155 au niveau de la périphérie des ouvertures 155d, 155e des pattes 155b, 155c. La tige 155a est en outre munie, dans une partie centrale, d'une pâte 155f destinée à être mise en contact mécaniquement et électriquement avec une borne de référence de la carte de circuit imprimé 112.

L'assemblage des modules élémentaires 110 et leur fixation sur la structure de support 130 peuvent être réalisés comme suit.

Les cartes de circuit imprimé 112 sont préparées en amont de la phase d'assemblage. Les cartes de circuit imprimé 112 et les pièces conductrices 155 peuvent ensuite être montées sur les cadres de support 153. Dans chaque module 110, une vis de serrage non représentée peut être prévue pour assurer la fixation de la carte de circuit imprimé 112 et de la pièce conductrice 155 au cadre 153. Cette vis permet en outre d'assurer un bon contact électrique entre la borne de référence de la carte de circuit imprimé 112 et la patte de contact 155f de la pièce conductrice 155. Le carter de protection 120 peut ensuite être clipsé sur le cadre 153, au-dessus de la carte de circuit imprimé 112.

Les modules élémentaires 110 peuvent ensuite être enfilés en colonne sur les tiges conductrices 131 de la structure de support 130.

Un dispositif de serrage (non détaillée sur la figure) peut être prévu aux extrémités de chaque tige 131 pour assurer le serrage vertical des modules élémentaires 110 de chaque colonne. A titre d'exemple, les tiges 131 sont filetées, et le dispositif de serrage comprend, pour chaque tige 131, un écrou (non détaillé sur les figures) vissé du côté de l'extrémité inférieure et/ou un écrou (non détaillé sur les figures) vissé du côté de l'extrémité supérieure de la tige filetée, assurant le serrage vertical de la colonne. Plus généralement, tout autre système de serrage équivalent peut être prévu.

Dans l'exemple décrit ci-dessus, le carter de protection 120 est adapté à transmettre la lumière émise par l'ensemble de LED 114 sans altération significative. A titre de variante, le carter de protection 120 peut avoir toute autre fonction optique souhaitée, par exemple une fonction de lentille, ou une fonction d'orientation de la lumière dans une direction déterminée (prisme).

La figure 5 est une vue de face partielle éclatée d'un exemple d'un dispositif d'éclairage à LED selon un mode de réalisation.

Le dispositif de la figure 5 comprend une structure éclairante 100 identique ou similaire à la structure décrite en relation avec la figure 1.

Le dispositif de la figure 5 comprend en outre, fixé sous la platine 133 inférieure de la structure éclairante, un ventilateur 160, aussi appelé ventilateur thermique, destiné à brasser l'air situé à l'intérieur du volume délimité par les modules élémentaires 110, afin de faciliter l'évacuation de la chaleur générée par les LED.

Le dispositif de la figure 5 comprend de plus, fixé sous la platine 133 inférieure de la structure éclairante, un étage de service 170 comportant notamment des circuits électroniques d'alimentation et de contrôle de la structure éclairante. L'étage de service 170 peut comprendre une structure de support du même type que celle de la structure éclairante. Les circuits électroniques d'alimentation et de contrôle peuvent être montés sur une ou plusieurs cartes de circuit imprimé 172 fixées sur la structure de support, par exemple au moyen de supports de fixation du même type que les supports 150 de la structure éclairante.

Dans cet exemple, le dispositif d'éclairage est un dispositif de type ballon éclairant, comportant une enveloppe gonflable, non représentée sur la figure 5, enveloppant la structure éclairante 100 et l'étage de service 170.

Pour permettre le gonflage de l'enveloppe, l'étage de service comprend un ventilateur 174, appelé ventilateur de gonflage, adapté à aspirer de l'air en partie inférieure du dispositif, pour l'injecter dans l'enveloppe.

Dans l'exemple représenté, le dispositif comprend en outre un mat de support 180 fixé à une platine inférieure de l'étage de service 170.

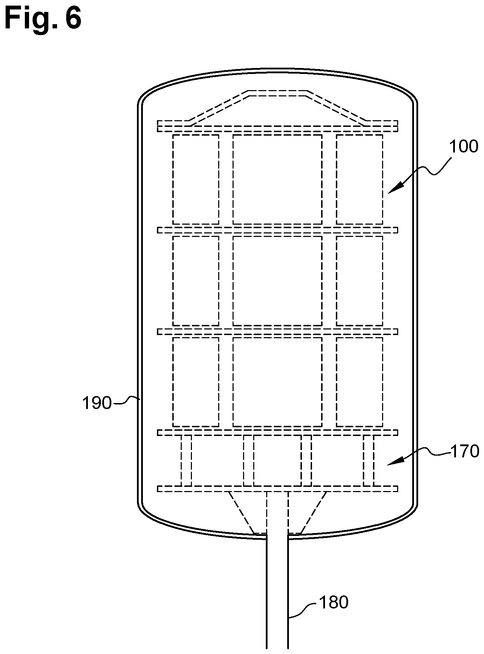

La figure 6 est une vue de face schématique d'un ballon éclairant à enveloppe gonflable du type décrit ci-dessus.

Sur la figure 6, la structure éclairante 100, l'étage de service 170 et le mat de support 180 ont été représentés schématiquement par des traits en pointillé.

Dans cet exemple, le dispositif d'éclairage comprend une enveloppe gonflable 190 entourant l'ensemble comprenant la structure éclairante 100 et l'étage de service 170. L'enveloppe 190 est une enveloppe souple, par exemple une enveloppe textile. L'enveloppe 190 est de préférence étanche à l'eau et à l'air et permet de protéger l'ensemble des composants mécaniques et électroniques de la structure éclairante et de l'étage de service contre des agressions extérieures. L'enveloppe 190 peut également jouer un rôle de diffuseur optique pour la lumière émise par la structure éclairante. Autrement dit, l'enveloppe 190 est adaptée à transmettre, en la diffusant, la lumière émise par la structure éclairante.

Le gonflage de l'enveloppe 190 est assuré par le ventilateur de gonflage 174 (non visible sur la figure 6), à la mise en service du dispositif d'éclairage.

On notera que les structures éclairantes décrites ci-dessus ne se limitent pas à une utilisation dans des dispositifs d'éclairage de type ballon gonflable. A titre de variante, l'enveloppe gonflable 190 peut être remplacée par une enveloppe souple non gonflable, par exemple tendue sur des armatures (non représentées) de la structure de support, ou encore par une enveloppe ou coque rigide. Dans ce cas, le ventilateur de gonflage 174 et les circuits électroniques d'alimentation et de commande associés peuvent être omis.

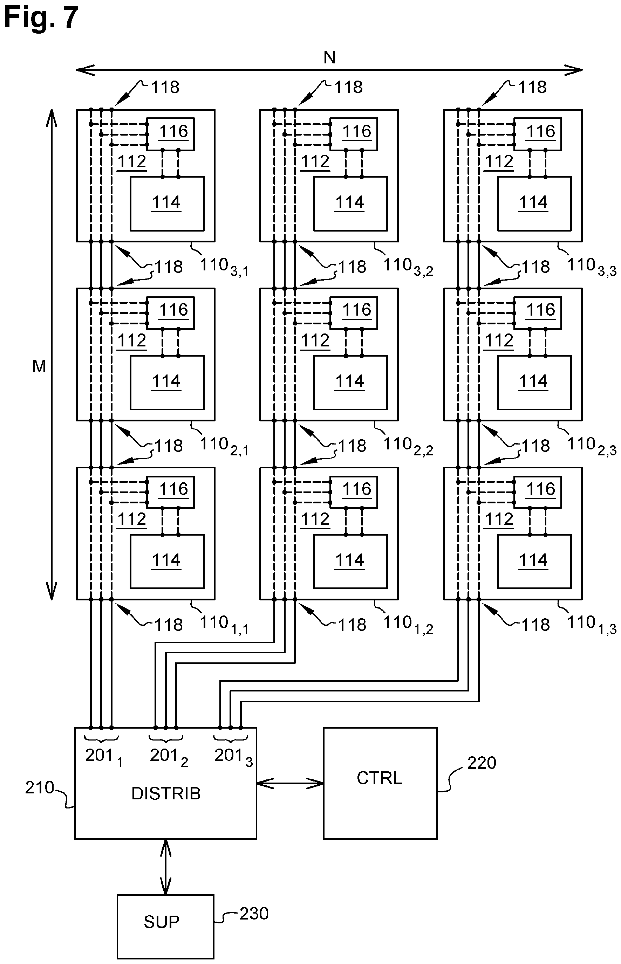

La figure 7 est un schéma électrique simplifié d'un dispositif d'éclairage à LED selon un mode de réalisation.

On notera que, dans les exemples de structures éclairantes décrits ci-dessus, quelle que soit la forme de la structure, les modules élémentaires 110 définissent une matrice de M rangée(s) par N colonne(s) avec M entier supérieur ou égal à 1 et N entier supérieur ou égal à 1. Le nombre M de rangées correspond au nombre d'étages de la structure. Le nombre N de colonnes correspond au nombre de modules élémentaires 110 par étage. Chaque rangée est définie par l'ensemble des N modules élémentaires 110 de l'étage correspondant. Chaque colonne est définie par l'ensemble des M modules élémentaires 110 de même position dans les différents étages. Ainsi, les M*N modules élémentaires 110 définissent un écran matriciel qui peut être planaire (dans l'exemple de la figure 3) ou enroulé sur lui-même (dans les exemples des figures 1 et 2).

Selon un aspect d'un mode de réalisation, on met en oeuvre un pilotage matriciel de la structure éclairante, dans lequel chaque module élémentaire 110, aussi appelé pixel, peut être contrôlé individuellement. La figure 7 illustre plus en détail un exemple d'un schéma d'interconnexion des modules élémentaires 110 et de circuits périphériques d'alimentation et de commande de la structure éclairante, permettant la mise en oeuvre d'un tel pilotage matriciel.

On notera qu'en fonction des applications considérées, certains modules élémentaires 110 de la matrice peuvent être omis. Autrement dit, on peut avoir une matrice à trous. En particulier, dans certaines configurations, différentes colonnes peuvent présenter des nombres de modules élémentaires 110 différents, et/ou différentes rangées peuvent présenter des nombres de modules élémentaires 110 différents. La personne du métier saura adapter les solutions de pilotage décrites ci-après à de telles configurations.

Dans cet exemple, on a considéré une structure éclairante de 9 modules élémentaires 110 répartis en matrice selon M=3 rangées et N=3 colonnes. Les modes de réalisation décrits peuvent bien entendu être adaptés à toutes autres dimensions de matrice. On désignera ci-après par i, entier allant de 1 à M, le rang des modules élémentaires dans chaque colonne, où i=1 correspond au module 110 inférieur et i=M correspond au module 110 supérieur de la colonne, et par j, entier allant de 1 à N, le rang des modules élémentaires dans chaque rangée, où j=1 correspond au module 110 le plus à gauche et j=N correspond au module 110 le plus à droite dans la rangée. Par ailleurs, par souci de simplification, on désignera par la référence 110_{i,j} le module élémentaire 110 de la rangée i de la colonne j de la matrice.

Dans chacune des N colonnes de la matrice, les modules élémentaires 110 de la colonne sont reliés en chaine par leurs connecteurs 118 respectifs. Plus particulièrement, chaque module 110_{i,j}, à l'exception du module supérieur 110_{M,j}, est connecté, par son connecteur 118 supérieur, au connecteur 118 inférieur du module de rang 110_{i+1,j} de la même colonne. Le connecteur inférieur 118 du module inférieur 110_{1,j} de la colonne est connecté à un connecteur 201ⱼ spécifique à la colonne, d'une carte électronique de distribution 210 (DISTRIB). Dans cet exemple, le connecteur supérieur 118 du module supérieur 110_{M,j} de la colonne n'est pas connecté.

Dans cet exemple, chacun des connecteurs 118 et 201ⱼ est un connecteur à trois bornes. Plus particulièrement, deux bornes sont dédiées à la transmission d'une tension continue d'alimentation des modules 110, et la troisième borne est dédiée à la transmission d'un signal de commande des modules 110, par exemple un signal numérique sérialisé.

Dans chaque module élémentaire 110, la carte de circuit imprimé 112 du module comprend trois pistes conductrices distinctes connectant respectivement les trois bornes du connecteur 118 inférieur du module aux trois bornes du connecteur 118 supérieur du module. Pour chaque colonne, la connexion entre le connecteur 201ⱼ de la carte de distribution 210 et le connecteur 118 inférieur du module 110_{1,j}, et les connexion de proche en proche entre modules voisins de la colonne peuvent être réalisées au moyen de fils conducteurs, par exemple au moyen de nappes conductrices à trois fils ou au moyen de conducteurs rigides.

Dans chaque module élémentaire 110, le circuit d'alimentation et de contrôle 116 du module reçoit les signaux d'alimentation et de commande propagés par l'intermédiaire des connecteurs 118, et commande en conséquence l'ensemble de LED 114 du module.

Dans cet exemple, les modules élémentaires 110 de colonnes distinctes ne sont pas directement connectés les uns aux autres.

Le dispositif de la figure 7 comprend en outre une carte électronique de contrôle 220 (CTRL), reliée à la carte de distribution 210, adaptée notamment à générer et à transmettre à la carte de distribution 210 les signaux de contrôle des modules élémentaires 110 de la structure éclairante. La carte de distribution 210 et la carte de contrôle 220 sont par exemple réalisées sur deux cartes de circuit imprimé distinctes. La carte de distribution 210 et la carte de contrôle 220 sont par exemple montées sur l'étage de service 170 (figures 5 et 6) du dispositif d'éclairage.

La carte de distribution 210 peut être reliée à une unité d'alimentation 230 (SUP) elle-même reliée à une ou plusieurs sources d'alimentation électrique (non détaillées), par exemple une source d'alimentation continue telle qu'une batterie électrique et/ou une source d'alimentation alternative, par exemple la tension secteur.

Le dispositif d'éclairage peut en outre comprendre un dispositif d'interface utilisateur, non représenté, relié à la carte électronique de contrôle 220 par une liaison filaire ou sans fil. L'interface utilisateur peut par exemple prendre la forme d'une application sur un smartphone relié à la carte électronique de contrôle 220 par des moyens de communication sans fil.

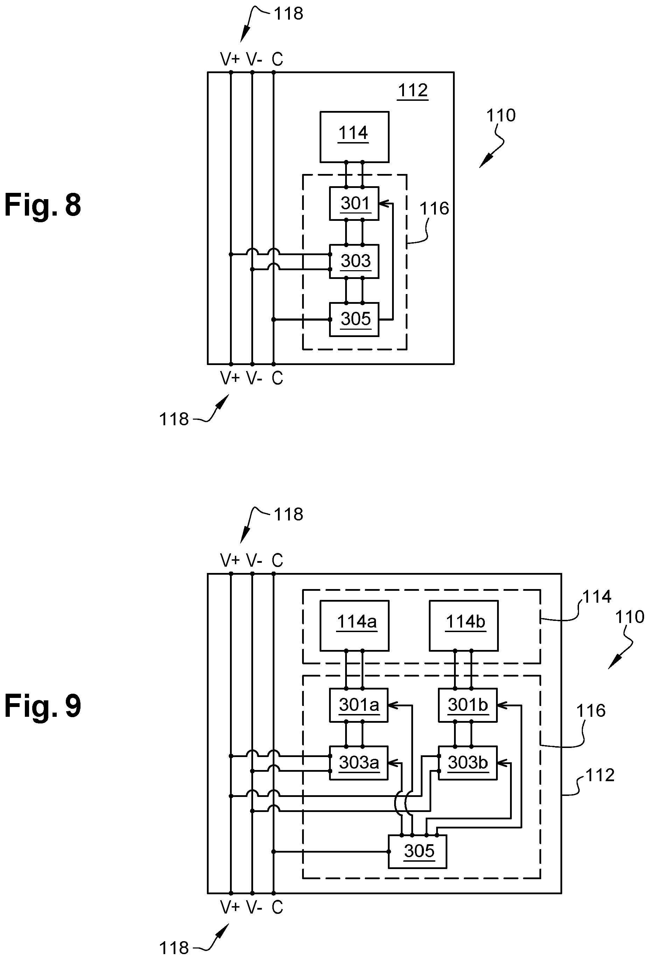

La figure 8 illustre plus en détail un exemple de réalisation d'un module d'éclairage élémentaire 110 du dispositif d'éclairage à LED de la figure 7.

Sur la figure 8, les trois bornes de connexion de chaque connecteur 118 ont été détaillées. Les bornes V+ et V-correspondent respectivement à une borne positive et à une borne négative d'application de la tension d'alimentation continue du module 110. Le potentiel appliqué sur la borne V-correspond par exemple au potentiel de référence ou potentiel de référence du module. Ainsi, dans un assemblage du type décrit en relation avec les figures 1 à 4, la borne de référence (non détaillée sur les figures) connectée électriquement à la structure de support 130 par l'intermédiaire de la pièce métallique 155 du support de fixation 150 est une plage ou piste conductrice de la carte de circuit imprimé 112 connectée aux bornes V- des connecteurs 118 du module.

Dans cet exemple, le module 110 est un panneau d'éclairage à LED blanches. Le même principe pourra toutefois être appliqué à des LED couleur, ultraviolettes, infrarouge, ou à toute autre gamme de longueurs d'ondes d'émission lumineuse. L'ensemble de LED 114 est constitué par une association en série de LED blanches (non détaillées sur la figure), par exemple identiques ou similaires, et comprend deux bornes d'alimentation reliées respectivement à l'anode de la première LED et à la cathode de la dernière LED de l'association en série.

Le circuit d'alimentation et de commande 116 comprend un circuit d'alimentation 301 et un commutateur de puissance 303. Le commutateur 303 comprend deux bornes d'entrée connectées respectivement aux bornes d'alimentation V+ et V-du module 110, et deux bornes de sortie connectées respectivement à deux bornes d'entrée du circuit d'alimentation 301. Le circuit d'alimentation 301 comprend en outre deux bornes de sortie connectées respectivement aux deux bornes d'alimentation de l'ensemble de LED 114.

Lorsque le commutateur 303 est dans un premier état, appelé état passant, les bornes d'entrée du circuit d'alimentation 301 sont connectées respectivement aux bornes d'alimentation V+ et V- du module, de sorte que la tension d'alimentation du module 110 est appliquée en entrée du circuit d'alimentation 301. Le circuit d'alimentation 301 fournit alors, entre ses bornes de sortie, un courant ou une tension d'alimentation provoquant l'allumage des LED. De préférence, le circuit d'alimentation 301 est un convertisseur continu-continu (DC-DC) à courant de sortie constant, présentant l'avantage d'être particulièrement adapté à l'alimentation de LED. A titre d'exemple, la tension d'alimentation du module 110 est comprise entre 10 et 100 volts, par exemple de l'ordre de 50 volts.

Lorsque le commutateur 303 est dans un deuxième état, appelé état bloqué, les bornes d'entrée du circuit d'alimentation 301 sont isolées des bornes d'alimentation V+ et V- du module, de sorte que la tension d'alimentation du module n'est pas appliquée en entrée du circuit d'alimentation 301. Les LED ne sont alors pas alimentées et restent éteintes. En pratique, le commutateur 303 peut avoir d'autres fonctions que la fonction de commutation susmentionnée, par exemple une fonction de limitation du courant d'appel au démarrage et/ou une fonction de remise en forme de la logique d'allumage/extinction, par exemple pour éviter un flash à la mise sous-tension du produit.

Dans cet exemple, le circuit d'alimentation et de commande 116 du module comprend en outre un circuit de contrôle 305, par exemple un circuit numérique. Le circuit de contrôle 305 est connecté à une borne de contrôle C du module 110. Ainsi, le circuit 305 reçoit le signal de commande propagé de proche en proche dans chaque colonne de la matrice de modules 110. Le circuit 305 est adapté à interpréter ce signal et à commander en conséquence le commutateur 303 et/ou le circuit d'alimentation 301. A titre d'exemple, le circuit 305 est adapté à commander le commutateur 303 à l'état ouvert ou fermé pour allumer ou éteindre les LED du module 110. Le circuit 305 peut en outre être adapté à commander le circuit d'alimentation 301 pour faire varier la puissance électrique fournie aux LED de l'ensemble 114, et ainsi faire varier la puissance lumineuse émise par le module.

La figure 9 illustre une variante de réalisation du module d'éclairage élémentaire 110 de la figure 8.

Dans cet exemple, l'ensemble de LED 114 comprend deux sous-ensembles de LED 114a et 114b. Les LED du sous ensemble 114a et les LED du sous ensemble 114b ont des propriétés d'émission différentes. A titre d'exemple, les LED du sous-ensemble 114a sont adaptées à émettre de la lumière blanche froide, et les LED du sous-ensemble 114b sont adaptées à émettre de la lumière blanche chaude. Chaque sous-ensemble est par exemple constitué d'une association en série d'une pluralité de LED élémentaires identiques ou similaires.

Le circuit d'alimentation et de commande 116 comprend deux circuits d'alimentation 301a et 301b, et deux commutateurs de puissance 303a et 303b. Chacun des commutateurs 303a et 303b comprend deux bornes d'entrée connectées respectivement aux bornes d'alimentation V+ et V-du module 110. Le commutateur 303a comprend deux bornes de sortie connectées respectivement à deux bornes d'entrée du circuit d'alimentation 301a. Le commutateur 303b comprend deux bornes de sortie connectées respectivement à deux bornes d'entrée du circuit d'alimentation 301b. Le circuit d'alimentation 301a comprend deux bornes de sortie connectées respectivement aux deux bornes d'alimentation du sous-ensemble de LED 114a. Le circuit d'alimentation 301b comprend deux bornes de sortie connectées respectivement aux deux bornes d'alimentation du sous-ensemble de LED 114b.

Lorsque le commutateur 303a est dans un premier état, appelé état passant, les bornes d'entrée du circuit d'alimentation 301a sont connectées respectivement aux bornes d'alimentation V+ et V- du module. Le circuit d'alimentation 301a fournit alors, entre ses bornes de sortie, un courant ou une tension d'alimentation provoquant l'allumage des LED du sous-ensemble 114a. De façon similaire, lorsque le commutateur 303b est dans un premier état, appelé état passant, les bornes d'entrée du circuit d'alimentation 301b sont connectées respectivement aux bornes d'alimentation V+ et V-du module. Le circuit d'alimentation 301b fournit alors, entre ses bornes de sortie, un courant ou une tension d'alimentation provoquant l'allumage des LED du sous-ensemble 114b. Les circuits d'alimentation 301a et 301b sont par exemple des convertisseurs DC-DC à courant de sortie constant.

Lorsque le commutateur 303a est dans un deuxième état, appelé état bloqué, les bornes d'entrée du circuit d'alimentation 301a sont isolées des bornes d'alimentation V+ et V- du module, de sorte que les LED du sous-ensemble 114a ne sont pas alimentées. De façon similaire, lorsque le commutateur 303b est à l'état bloqué, les LED du sous-ensemble 114b ne sont pas alimentées.

Dans cet exemple, le circuit d'alimentation et de commande 116 du module comprend en outre un circuit de contrôle 305, par exemple un circuit numérique, connecté à la borne de contrôle C du module 110. Le circuit 305 reçoit le signal de commande propagé de proche en proche dans chaque colonne de la matrice de modules 110, et est adapté à commander en conséquence les commutateurs 303a et 303b et/ou les circuits d'alimentation 301a et 301b. A titre d'exemple, le circuit 305 est adapté à commander chacun des commutateurs 303a et 303b à l'état ouvert ou fermé pour allumer ou éteindre les LED du sous-ensemble 114a ou 114b correspondant. Le circuit 305 peut en outre être adapté à commander chacun des circuits d'alimentation 301a et 301b pour faire varier la puissance électrique fournie aux LED du sous-ensemble 114a ou 114b correspondant. Ceci permet de faire varier la puissance lumineuse émise et/ou le ton (de chaud à froid) de la lumière émise par le module. Plus généralement, la solution décrite ci-dessus permet de faire varier l'intensité de chaque canal, chaque canal fournissant un spectre de lumière définissant une teinte dans une bande passante allant du proche UV (ultraviolet) au proche IR (infrarouge) en couvrant tout le spectre du visible.

La variante de la figure 9 peut être adaptée à un nombre de sous-ensemble de LED de natures distinctes différent de deux. A titre d'exemple, l'ensemble de LED 114 peut comprendre une pluralité de sous-ensembles adaptés à émettre dans des gammes de longueurs d'onde distinctes, par exemple trois sous-ensembles de LED adaptés à émettre respectivement de la lumière majoritairement bleue, de la lumière majoritairement verte, et de la lumière majoritairement rouge. En modulant la puissance émise par les différents sous-ensembles, on peut ainsi contrôler la couleur d'émission du module.

Pour commander de façon individuelle les différents modules élémentaires 110 d'une même colonne, les données de commande des différents modules peuvent être transmises successivement sur le fil de contrôle de la colonne, selon une séquence prédéterminée. Dans chaque module d'éclairage 110, le circuit de contrôle 305 du module sait identifier le code de commande qui lui est destiné. La mise en oeuvre d'un protocole de commande adapté sur un bus binaire est à la portée de la personne du métier à partir des indications fonctionnelles de la présente description et ne sera donc pas décrite plus en détail.

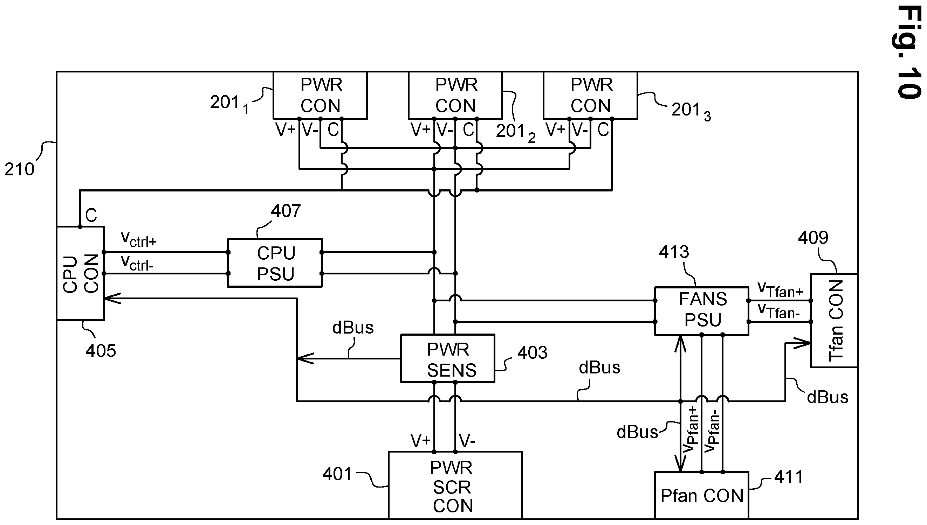

La figure 10 illustre de façon schématique un exemple de réalisation de la carte de distribution 210 d'un dispositif d'éclairage du type décrit en relation avec la figure 7.

Dans l'exemple de la figure 10, la carte de distribution 210 est adaptée à redistribuer des signaux d'alimentation et de contrôle depuis et vers différents organes du dispositif d'éclairage, parmi lesquels l'unité d'alimentation 230 (figure 7), la carte de contrôle 220 (figure 7) et la matrice de modules élémentaires 110 (figure 7). Dans cet exemple, la carte de distribution est en outre adaptée à distribuer des signaux d'alimentation et de contrôle depuis et/ou vers le ventilateur thermique 160 (figure 5) et le ventilateur de gonflage 174 (figure 5).

Outre les connecteurs 201ⱼ (PWR CON) destinés à être connectés respectivement aux connecteurs 118 inférieurs des modules élémentaires 110_{i,j} des différentes colonnes, la carte de distribution 210 de la figure 10 comprend un connecteur d'alimentation principal 401 (PWR SRC CON) destiné à être connecté à la source d'alimentation du dispositif. Le connecteur 401 comprend deux bornes V+ et V- d'application d'une tension d'alimentation continue principale, reliées respectivement, via des pistes conductrices de la carte 210, aux bornes d'alimentation V+ et V- des connecteurs 201ⱼ. La carte de distribution 210 peut en outre comprendre un multiplexeur (non détaillé sur la figure 10) adapté à sélectionner, le cas échéant, parmi les différentes sources d'alimentation disponibles, la source d'alimentation utilisée pour fournir la tension d'alimentation continue principale de la carte de distribution.

Dans cet exemple, la carte de distribution 210 comprend un capteur de puissance 403 (PWR SENS) connecté aux bornes V+ et V- du connecteur 401, adapté à mesurer la puissance électrique tirée sur les bornes d'alimentation principales V+ et V- du connecteur 401. A titre d'exemple, le capteur 403 comprend un capteur adapté à mesurer la tension entre les bornes V+ et V- du connecteur 401, et un capteur adapté à mesurer le courant circulant entres les bornes V+ et V- du connecteur 401.

On notera que dans l'exemple de la figure 10, la tension d'alimentation continue principale de la carte de distribution est appliquée directement (sans adaptation de niveau) entre les bornes V+ et V- de chaque connecteur 201ⱼ.

Dans l'exemple de la figure 10, la carte de distribution 210 comprend en outre un connecteur 405 (CPU CON) destiné à être connecté à la carte électronique de contrôle 220 (figure 7) du dispositif d'éclairage. Le connecteur 401 comprend deux bornes v_{ctrl}+ et v_{ctrl}- adaptées à fournir une tension continue d'alimentation de la carte électronique 220, par exemple une tension inférieure à la tension d'alimentation continue principale de la carte de distribution, par exemple une tension de l'ordre de 5V. Les bornes v_{ctrl}+ et v_{ctrl}- correspondent respectivement à une borne positive et à une borne négative d'application de la tension d'alimentation continue de la carte de contrôle. Le potentiel appliqué sur la borne v_{ctrl}- correspond par exemple au potentiel de référence (ou potentiel de masse) appliqué sur les bornes V- des connecteurs 401 et 201ⱼ.

Pour générer la tension d'alimentation de la carte de contrôle 220, la carte de distribution 210 comprend en outre un circuit d'alimentation 407 (CPU PSU), par exemple un convertisseur DC-DC, ayant deux bornes d'entrée reliées respectivement aux bornes V+ et V- du connecteur 401, et deux bornes de sortie reliées, par exemple connectées, respectivement aux bornes v_{ctrl}+ et v_{ctrl}-.

Le connecteur 405 comprend en outre une borne C destinée à être connectée à une borne de fourniture d'un signal de commande de la carte de contrôle 220. La borne C du connecteur 405 est connectée aux bornes C des connecteurs 201ⱼ.

Dans l'exemple de la figure 10, la carte de distribution 210 comprend de plus un connecteur 409 (Tfan CON) destiné à être connecté au ventilateur thermique 160 (figure 5) du dispositif, et un connecteur 411 (Pfan CON) destiné à être connecté au ventilateur de gonflage 174 (figure 5) de dispositif.

Le connecteur 409 comprend deux bornes v_{Tfan}+ et v_{Tfan}-adaptées à fournir une tension continue d'alimentation du ventilateur thermique 160, par exemple une tension inférieure à la tension d'alimentation continue principale de la carte de distribution, par exemple une tension de l'ordre de 24V. Les bornes v_{Tfan}+ et v_{Tfan}- correspondent respectivement à une borne positive et à une borne négative d'application de la tension d'alimentation continue du ventilateur thermique. Le potentiel appliqué sur la borne v_{Tfan}- correspond par exemple au potentiel de référence (ou potentiel de masse) appliqué sur la borne V- du connecteur 401.

De façon similaire, le connecteur 411 comprend deux bornes v_{Pfan}+ et v_{Pfan}- adaptées à fournir une tension continue d'alimentation du ventilateur de gonflage 174, par exemple une tension inférieure à la tension d'alimentation continue principale de la carte de distribution, par exemple une tension de l'ordre de 24V. Les bornes v_{Pfan}+ et v_{Pfan}-correspondent respectivement à une borne positive et à une borne négative d'application de la tension d'alimentation continue du ventilateur thermique. Le potentiel appliqué sur la borne v_{Pfan}- correspond par exemple au potentiel de référence (ou potentiel de masse) appliqué sur la borne V- du connecteur 401.

Dans cet exemple, pour générer les tensions d'alimentation du ventilateur thermique et du ventilateur de gonflage, la carte de distribution 210 comprend un circuit d'alimentation 413 (FANS PSU), par exemple un convertisseur DC-DC, ayant deux bornes d'entrée reliées respectivement aux bornes V+ et V- du connecteur 401, deux bornes de sortie reliées, par exemple connectées, respectivement aux bornes v_{Tfan}+ et v_{Ttan}-, et deux bornes de sortie reliées, par exemple connectées, respectivement aux bornes V_{Pfan}+ et V_{Pfan}-.

La carte de distribution 210 de la figure 10 comprend en outre un ou plusieurs bus dBUS de transmission de signaux de commande, par exemple numériques. Dans l'exemple représenté, un bus de transmission de signaux de commande dBus relie notamment un port de contrôle du connecteur 411 à un port d'entrée-sortie de données du connecteur 405. Dans cet exemple, un bus de transmission de signaux de commande dBus relie en outre un port de sortie de données du capteur de puissance 403 au port d'entrée-sortie de données du connecteur 405. Un bus de transmission de signaux de commande dBus relie de plus un port de contrôle du connecteur 409 et un port de contrôle du circuit d'alimentation 413 au port d'entrée-sortie de données du connecteur 405.

La réalisation de la carte de contrôle 220 du dispositif de la figure 7 n'a pas été détaillée. La carte de contrôle 220 peut comprendre un ou plusieurs circuits de calcul et de traitement, par exemple un microprocesseur et/ou un microcontrôleur, et/ou un ou plusieurs circuits mémoire.

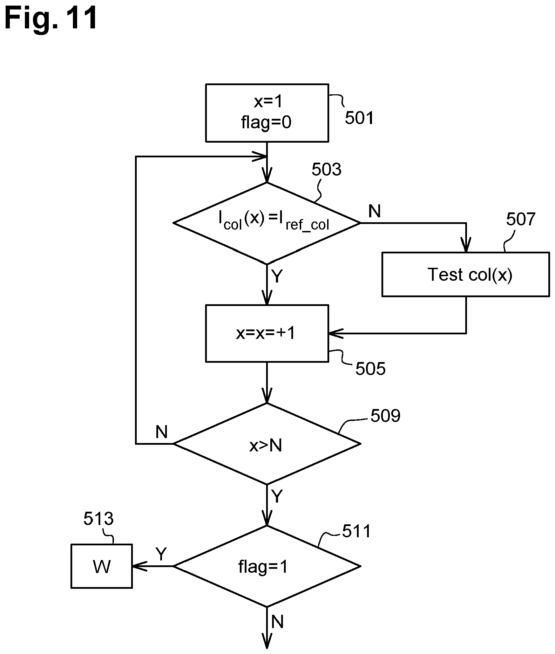

La figure 11 illustre schématiquement, sous forme de blocs, des étapes d'un exemple d'un procédé de détection de défauts dans un dispositif d'éclairage à LED du type décrit ci-dessus. Ce procédé peut être mis en oeuvre au démarrage du dispositif d'éclairage et/ou en cours d'utilisation, par exemple à intervalles périodiques, et vise à détecter et localiser un éventuel module élémentaire 110 défaillant. Le procédé de la figure 11 peut être mis en oeuvre au moyen des cartes électroniques de distribution 210 et de contrôle 220 (figure 7) du dispositif.

Le procédé de la figure 11 consiste à tester l'une après l'autre toutes les colonnes de la matrice de modules élémentaires 110 en vue d'identifier une éventuelle anomalie dans la colonne, et, lorsqu'une anomalie est détectée, à tester l'un après l'autre tous les modules élémentaires 110 de la colonne pour identifier le module défaillant.

Lors d'une étape 501, un indice de colonne x est initialisé à la valeur du rang de la première colonne de la matrice (x=1). A cette étape, un indicateur de défaut flag, par exemple binaire, est initialisé à une valeur correspondant à une absence de défaut (flag=0).

Lors d'une étape 503 le courant I_{col}(x) consommé par la colonne de rang j=x est estimé. Pour cela, tous les modules élémentaires 110 des colonnes de rang j différent de x sont désactivés, c'est-à-dire commandés à l'état éteint, et tous les modules élémentaires de la colonne de rang j=x sont activés, c'est-à-dire commandés à l'état allumé. Le courant circulant entre les bornes V+ et V- du connecteur 401 est alors mesuré au moyen du capteur de puissance 403. On obtient ainsi une estimation du courant I_{col}(x) consommé par la colonne de rang j=x (en considérant la somme des courants consommés par les colonnes désactivées de la matrice, par la carte électronique de contrôle, et par les ventilateurs, comme négligeable ou connue).

Lors de l'étape 503, le courant I_{col}(x) est comparé à une valeur nominale de référence I_{ref_col}, par exemple stockée dans un circuit mémoire de la carte électronique de contrôle 220. La valeur I_{ref_col} correspond au courant circulant normalement dans une colonne de la matrice de modules élémentaires 110 en l'absence de défaut dans cette colonne.

Si, à l'étape 503, le courant I_{col}(x) mesuré est égal ou sensiblement égal (avec une marge de tolérance prédéterminée, par exemple plus ou moins dix pourcents près) à la valeur I_{ref_col} (Y), on peut considérer que la colonne fonctionne correctement. Dans ce cas, le rang x est incrémenté à une étape 505 (x=x+1).

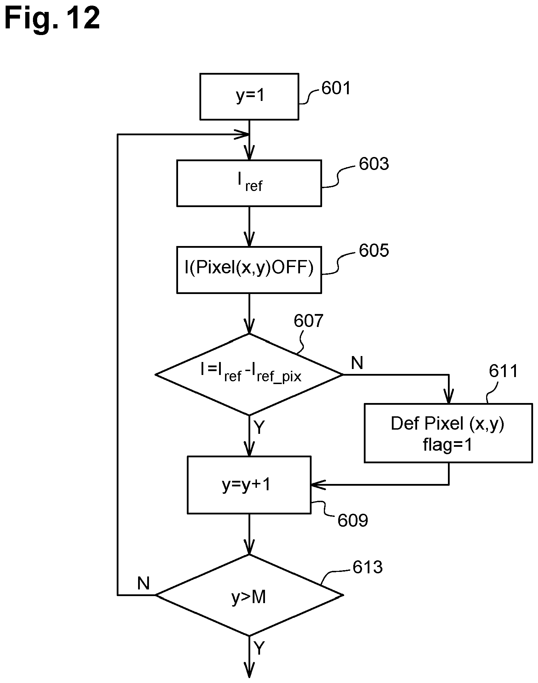

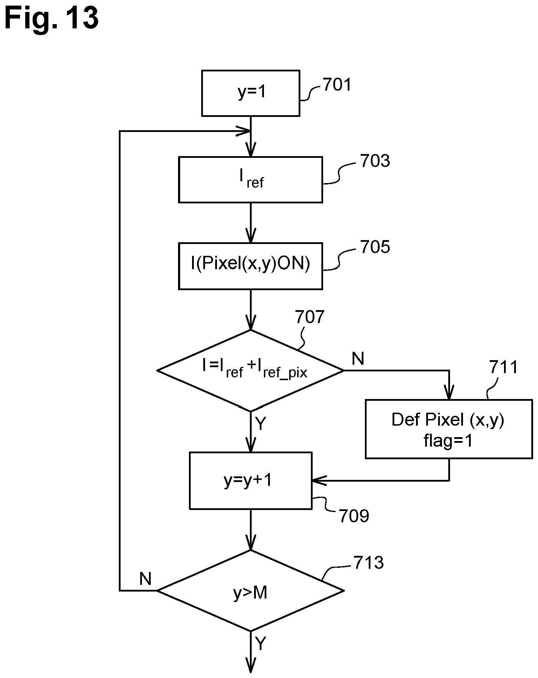

Dans le cas contraire (N), on peut supposer qu'au moins un module élémentaire 110 de la colonne est défaillant. Dans ce cas, les modules élémentaires 110 de la colonne sont testés un par un lors d'une étape 507 (Test Col(x)). Des exemples de mise en oeuvre de l'étape 507 seront décrits plus en détail ci-après en relation avec les figures 12 et 13. Si, à l'étape 507, un module 110 de la colonne est considéré comme défaillant, l'indicateur de défaut flag est mis à une valeur correspondant à une présence de défaut (flag=1). A l'issue de l'étape 507, l'étape 505 d'incrémentation du rang x est mise en oeuvre (x=x+1).

Après l'étape 505, on vérifie, lors d'une étape 509, si l'ensemble des colonnes a été testé (x>N). Si ce n'est pas le cas (N) les étapes 503, 507 (le cas échéant), 505 et 509 sont réitérées.

Si toutes les colonnes ont été testées (Y), on détermine, lors d'une étape 511, si l'indicateur de défaut flag est à une valeur correspondant à une présence de défaut (flag=1). Si c'est le cas (Y), une alerte, par exemple une alerte lumineuse, peut être émise lors d'une étape 513 (W) . Si aucun défaut n'a été détecté (N), le procédé se termine.

La figure 12 illustre un exemple de mise en oeuvre de l'étape 507 de test d'une colonne de rang j=x du procédé de la figure 11.

Le procédé de la figure 12 consiste à tester l'un après l'autre tous les modules élémentaires 110 de la colonne de rang j=x en vue d'identifier un éventuel module défaillant.

Lors d'une étape 601, un indice de rangée y est initialisé à la valeur du rang de la première rangée de la matrice (y=1).

Ensuite, lors d'une étape 603, tous les modules élémentaires 110 de la matrice sont commandés à l'état allumé. On mesure alors, au moyen du capteur 403, un courant I_{ref} représentatif du courant total circulant dans le dispositif.

Lors d'une étape 605, le module élémentaire 110_{y,x} est désactivé (commandé à l'état éteint). Les autres modules élémentaires 110 du dispositif restent commandés à l'état allumé, et le courant total I circulant dans le dispositif est mesuré au moyen du capteur 403.

Lors d'une étape 607, le courant I mesuré à l'étape 605 est comparé à la différence entre le courant I_{ref} mesuré à l'étape 603 et une valeur nominale de référence I_{ref_pix}, par exemple stockée dans un circuit mémoire de la carte électronique de contrôle 220. La valeur I_{ref_pix} correspond au courant circulant normalement dans un module élémentaire 110 en l'absence de défaut du module.

Si, à l'étape 607, le courant I est égal ou sensiblement égal (avec une marge de tolérance prédéterminée, par exemple plus ou moins dix pourcents près) à la valeur I_{ref}-I_{ref_pix} (Y), on peut considérer que le module fonctionne correctement. Dans ce cas, le rang y est incrémenté à une étape 609 (y=y+1).

Dans le cas contraire (N), on peut supposer que le module 110_{y,x} est défaillant. L'indicateur de défaut flag est alors mis à une valeur correspondant à une présence de défaut (flag=1) lors d'une étape 611. Les coordonnées du module défaillant dans la matrice peuvent en outre être mémorisées, par exemple en vue d'être transmises à un utilisateur via une interface utilisateur non détaillée. A l'issue de l'étape 611, l'étape 609 d'incrémentation du rang y est mise en oeuvre (y=y+1) .

Après l'étape 609, on vérifie, lors d'une étape 613, si l'ensemble des modules de la colonne de rang x a été testé (y>M). Si ce n'est pas le cas (N) les étapes 603, 605, 607, 611 (le cas échéant), 609 et 613 sont réitérées.

Si tous les modules de la colonne ont été testés (Y), l'étape de test de la colonne se termine.

Le procédé de la figure 12 est un procédé d'analyse soustractive particulièrement adapté à la détection de défauts générant une baisse de consommation du module défaillant. Il permet de limiter au minimum l'extinction des modules pendant la phase de test, ce qui est tout particulièrement avantageux lorsque le test est mis en oeuvre en cours d'utilisation du dispositif.

La figure 13 illustre un autre exemple de mise en oeuvre de l'étape 507 de test d'une colonne de rang j=x du procédé de la figure 11.

Là encore, on vient tester l'un après l'autre tous les modules élémentaires 110 de la colonne de rang j=x en vue d'identifier un éventuel module défaillant.

Lors d'une étape 701, un indice de rangée y est initialisé à la valeur du rang de la première rangée de la matrice (y=1).

Ensuite, lors d'une étape 703, tous les modules élémentaires 110 de la matrice à l'exception des modules élémentaires de la colonne de rang j=x sont commandés à l'état allumé. Les modules élémentaires de la colonne de rang j=x sont tous commandés à l'état éteint. On mesure alors, au moyen du capteur 403, un courant I_{ref} représentatif du courant total circulant dans le dispositif.

Lors d'une étape 705, le module élémentaire 110_{y,x} est activé (commandé à l'état allumé). Les autres modules élémentaires 110 du dispositif restent commandés dans le même état qu'à l'étape 703. Le courant total I circulant dans le dispositif est alors mesuré au moyen du capteur 403.

Lors d'une étape 707, le courant I mesuré à l'étape 705 est comparé à la somme I_{ref} + I_{ref_pix}.

Si, à l'étape 707, le courant I est égal ou sensiblement égal (avec une marge de tolérance prédéterminée, par exemple plus ou moins dix pourcents près) à la valeur I_{ref}+I_{ref_pix} (Y), on peut considérer que le module fonctionne correctement. Dans ce cas, le rang y est incrémenté à une étape 709 (y=y+1).

Dans le cas contraire (N), on peut supposer que le module 110_{y,x} est défaillant. L'indicateur de défaut flag est alors mis à une valeur correspondant à une présence de défaut (flag=1) lors d'une étape 711. Les coordonnées du module défaillant dans la matrice peuvent en outre être mémorisées, par exemple en vue d'être transmises à un utilisateur via une interface utilisateur non détaillée. A l'issue de l'étape 711, l'étape 709 d'incrémentation du rang y est mise en oeuvre (y=y+1).

Après l'étape 709, on vérifie, lors d'une étape 713, si l'ensemble des modules de la colonne de rang x a été testé (y>M). Si ce n'est pas le cas (N) les étapes 703, 705, 707, 711 (le cas échéant), 709 et 713 sont réitérées.

Si tous les modules de la colonne ont été testés (Y), l'étape de test de la colonne se termine.

Le procédé de la figure 13 est un procédé d'analyse additive particulièrement adapté à la détection de défauts générant une surconsommation du module défaillant.

En fonction des besoins de l'application, on pourra choisir, à l'étape 507 du procédé de la figure 11, d'appliquer l'un ou l'autre des procédés des figures 12 et 13, ou encore les deux successivement.

On notera que la valeur de référence I_{ref_col} utilisée à l'étape 503 (figure 11) est choisie en fonction du niveau de la consigne de puissance lumineuse appliquée aux modules élémentaires lors de la phase de mesure du courant I_{col}(x). De façon similaire, la valeur de référence I_{ref_pix} utilisée à l'étape 607 (figure 12) ou 707 (figure 13) est choisie en fonction du niveau de la consigne de puissance lumineuse appliquée aux modules élémentaires lors de la phase de mesure du courant I_{ref} (étape 603 ou 703). A titre d'exemple, la carte électronique de contrôle 220 peut mémoriser plusieurs valeurs de référence I_{ref_col} et plusieurs valeurs de référence I_{ref_pix}, correspondant respectivement à différents niveaux de consigne de puissance d'éclairage des modules élémentaires. Pour un diagnostic au démarrage, les modules élémentaires sont de préférence commandés à un niveau de luminosité relativement faible, par exemple inférieur à 20 pourcents de leur luminosité maximale. En particulier, dans le cas d'un ballon éclairant à enveloppe gonflable, l'enveloppe du ballon peut ne pas être encore gonflée lors de la phase de diagnostic. Réaliser le diagnostic à un niveau de luminosité faible permet alors de limiter les contraintes thermiques dans le dispositif.

Plus généralement, d'autres stratégies de test que celles décrites en relation avec les figures 11, 12 et 13 peuvent être mises en oeuvre, sur la base de mesures de puissance consommée et de comparaison des puissances mesurées à des valeurs de référence.

A titre d'exemple, pour un diagnostic en cours d'utilisation, on peut privilégier un test systématique de tous les modules 110 par analyse soustractive, module par module. Autrement dit, le procédé de la figure 12 est mis en oeuvre successivement dans toutes les colonnes de la matrice, en omettant l'étape de sélection préalable des colonnes suspectes (étape 503 de la figure 11). Ceci permet de limiter la perte de flux lumineux à l'équivalent d'un seul module 110.

A titre de variante, pour un diagnostic en service après-vente, on pourra appliquer un test systématique de tous les modules 110 par analyse additive, module par module. Autrement dit, le procédé de la figure 13 est mis en oeuvre successivement dans toutes les colonnes de la matrice, en omettant l'étape de sélection préalable des colonnes suspectes (étape 503 de la figure 11). De plus, lors de l'étape 703 de mesure du courant de référence, tous les modules élémentaires 110 de la matrice sont commandés à l'état éteint. Ceci permet de limiter la consommation électrique pendant la phase de test.

Lorsqu'un module défaillant est identifié, des tests complémentaires plus poussés peuvent être mis en oeuvre pour déterminer la cause de la panne.

On notera par ailleurs que les méthodes de diagnostic décrites ci-dessus en relation avec les figures 11, 12 et 13 peuvent s'appliquer à tout dispositif d'éclairage comportant une pluralité de modules élémentaires 110 agencés en colonne, y compris lorsque la structure de support du dispositif est non conductrice et/ou n'assure pas la fonction d'équipotentialité des potentiels de référence des différents modules élémentaires 110.

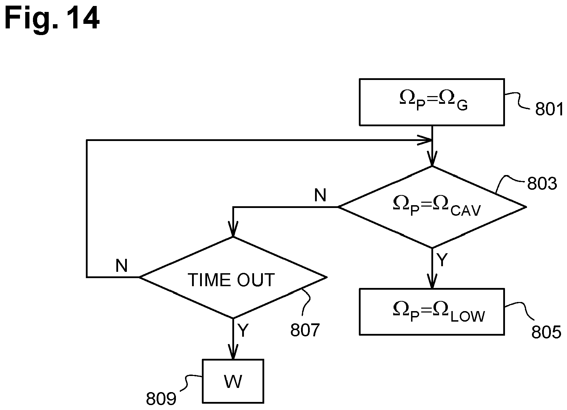

La figure 14 illustre schématiquement, sous forme de blocs, un exemple d'un procédé de contrôle du gonflage d'une enveloppe d'un ballon éclairant à enveloppe gonflable selon un mode de réalisation. Ce procédé peut être mis en oeuvre à la mise en service du dispositif, lors de gonflage de l'enveloppe. Le procédé de la figure 14 peut par exemple être mis en oeuvre au moyen des cartes électroniques de distribution 210 et de contrôle 220 (figure 7) du dispositif.

Dans cet exemple, le ventilateur de gonflage 174 du dispositif est un ventilateur à vitesse variable comprenant un port d'entrée-sortie de données de contrôle, relié à la carte électronique de contrôle 220 par l'intermédiaire d'un bus de données, par exemple numériques, dBus de la carte de distribution 210. Le port d'entrée-sortie de contrôle du ventilateur 174 comprend notamment une ou plusieurs bornes d'entrée adaptées à recevoir un signal de consigne de puissance d'alimentation électrique du ventilateur. Le port d'entrée-sortie de contrôle du ventilateur comprend en outre une ou plusieurs bornes de sortie adaptées à fournir un signal retour représentatif de la vitesse de rotation effective du ventilateur, mesurée au moyen d'un capteur de vitesse de rotation (non détaillé sur les figures) intégré au ventilateur.

Avant la phase de gonflage, l'enveloppe est initialement dégonflée, et le ventilateur de gonflage est à l'arrêt.

Lors d'une étape 801, le ventilateur est commandé à sa puissance de gonflage, par exemple à sa puissance maximale de façon à obtenir un gonflage rapide de l'enveloppe. Tout au long de la phase de gonflage, le ventilateur injecte de l'air dans l'enveloppe du ballon. Pendant cette phase, la vitesse effective de rotation Ω_{P} du ventilateur se maintient à une valeur de gonflage Ω_{G}, par exemple sensiblement constante, qui dépend de la consigne de puissance appliquée.

A la fin de la phase de gonflage, c'est-à-dire lorsque l'enveloppe est remplie d'air, la pression d'air à l'intérieur du ballon se stabilise à une valeur légèrement supérieure à la pression extérieure. Le flux d'air déplacé par le ventilateur est alors réduit. Ceci conduit à une augmentation de la vitesse de rotation du ventilateur (pour une consigne de puissance donnée). On dit que le ventilateur entre en cavitation.

Selon un aspect d'un mode de réalisation, on prévoit de surveiller la vitesse effective de rotation du ventilateur de façon à détecter la cavitation et en déduire que le gonflage du ballon est terminé.

Lors d'une étape 803, la vitesse de rotation effective Ω_{P} du ventilateur est mesurée par la carte électronique de contrôle 220. La carte 220 détermine si la vitesse Ω_{P} mesurée correspond à une vitesse de cavitation Ω_{CAV}, supérieure à la vitesse de gonflage Ω_{G}.

Si la cavitation est détectée à l'étape 803 (Y), la consigne de puissance du ventilateur est réduite à une étape 805. La vitesse de rotation Ω_{P} du ventilateur est ainsi ramenée à une valeur Ω_{LOW}, par exemple inférieure à la valeur Ω_{G}. Ceci permet de maintenir une pression sensiblement constante dans le ballon pendant la phase d'utilisation, tout en limitant la consommation électrique et le bruit du ventilateur.

Si l'entrée en cavitation n'est pas détectée à l'étape 803 (N), on vérifie lors d'une étape 807 (TIME OUT) si le temps écoulé depuis le début de la phase de gonflage n'excède pas un seuil prédéfini, correspondant à une durée nominale maximale de gonflage.

Si il est déterminé à l'étape 807 que la durée maximale de gonflage n'est pas excédée (N), les étapes 803 et, le cas échéant, 807, peuvent être réitérées, par exemple à intervalles de temps réguliers.

Si il est déterminé à l'étape 807 que la durée maximale de gonflage est excédée (Y), on en déduit que l'enveloppe présente peut être une fuite d'air et une alerte est émise à l'attention de l'utilisateur lors d'une étape 809 (W).

Le procédé décrit en relation avec la figure 14 présente l'avantage de permettre une détection simple de la fin de la phase de gonflage, et, le cas échéant, d'une éventuelle fuite dans l'enveloppe du ballon.

D'autres procédés de contrôle et/ou de diagnostic basés sur une analyse d'un signal de retour vitesse du ventilateur peuvent être mis en oeuvre par la carte électronique de contrôle 220. A titre d'exemple, une détection d'une vitesse de rotation anormalement haute (pour une consigne de puissance donnée) peut permettre de déterminer qu'un filtre d'admission d'air du ventilateur est colmaté. Un message d'alerte peut alors être émis à l'attention de l'utilisateur, pour lui signaler que le filtre doit être nettoyé. Un défaut du ventilateur peut par ailleurs être détecté si l'on constate que la vitesse effective de rotation Ω_{P} du ventilateur n'est pas cohérente avec la consigne de puissance appliquée. Là encore, une alerte pourra être émise à l'attention de l'utilisateur. Si une panne du ventilateur de gonflage est détectée, une mise en sécurité de dispositif peut être activée. Par exemple, les modules élémentaires 110 peuvent être commandés à une puissance faible, par exemple de l'ordre de 10% de leur puissance maximale, pour éviter une éventuelle dégradation de l'enveloppe sous l'effet de la chaleur émise par les LED.

Les différentes alertes renvoyées à l'utilisateur peuvent être émises par l'intermédiaire d'un dispositif d'interface utilisateur (non détaillé) du dispositif d'éclairage, par exemple via un canal de communication sans contact, par exemple un canal de communication par ondes radio (par exemple de type Bluetooth), par exemple vers un terminal mobile de type smartphone ou vers un centre de maintenance distant. A titre de variante, les alertes peuvent être émises sous la forme de signaux lumineux, par exemple des séquences prédéfinies de flash successifs émis au moyen d'un ou plusieurs modules élémentaires 110 du dispositif.

On notera que le procédé de la figure 14 ne se limite pas à une mise en oeuvre dans un dispositif d'éclairage à LED matriciel du type décrit ci-dessus. Plus généralement, ce procédé de détection de fin de gonflage de la figure 14 peut être adapté à tout ballon éclairant comportant une enveloppe gonflable et un ventilateur de gonflage. En particulier, ce procédé peut être adapté à des ballons intégrant d'autres types de structures éclairantes que celles décrites ci-dessus, par exemple des structures à base de lampes à incandescence.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation ne se limitent pas aux exemples de valeurs numériques ni aux exemples de matériaux mentionnés dans la présente description.

En outre, dans les exemples d'assemblage décrits en relation avec les figures 1 à 5, le support de fixation 150 peut être remplacé par tout autre élément adapté à assurer à la fois la fonction de fixation mécanique des modules élémentaires 110 sur la structure de support 130, et la fonction de connexion électrique de bornes de référence des cartes de circuit imprimé 112 à la structure de support 130, de façon à assurer l'équipotentialité entre les bornes de référence des différents modules 110. A titre d'exemple, le support de fixation peut être remplacé par des pinces de fixation munies chacune d'une pièce conductrice connectant une borne de référence de la carte de circuit imprimé 112 à la structure de support 130.

## Revendications

1. Dispositif d'éclairage comportant :
- une structure de support (130) électriquement conductrice ; et
- une pluralité de modules d'éclairage élémentaires (110) fixés sur la structure de support, chaque module élémentaire comportant une carte de circuit imprimé (112) et, montés sur la carte de circuit imprimé, un ensemble (114) de LED et un circuit électronique (116) d'alimentation et de commande de l'ensemble de LED (114),
dans lequel, dans chaque module élémentaire (110), la carte de circuit imprimé (112) du module comprend au moins une borne de référence (V-), les bornes de référence (V-) des cartes de circuit imprimé (112) des différents modules élémentaires (110) étant connectées électriquement les unes aux autres par l'intermédiaire de la structure de support (130),
dans lequel les modules élémentaires (110) sont agencés selon une pluralité de colonnes comprenant chacune plusieurs modules élémentaires (110), chaque module comprenant deux connecteurs (118) d'alimentation et de contrôle, et les modules élémentaires (110) d'une même colonne étant connectés en chaine via leurs connecteurs (118) d'alimentation et de contrôle respectifs.

2. Dispositif selon la revendication 1, dans lequel chaque module élémentaire (110) comprend un support de fixation (150) du module sur la structure de support (130).

3. Dispositif selon la revendication 2, dans lequel, dans chaque module élémentaire (110) le support de fixation (150) du module comprend une pièce électriquement conductrice (155) connectant électriquement une borne de référence (V-) de la carte de circuit imprimé du module à la structure de support (130).

4. Dispositif selon la revendication 3, dans lequel ladite pièce électriquement conductrice (155) comprend une tige conductrice (155a) munie à ses extrémités de pattes conductrices (155b, 155c) comportant chacune une ouverture (155d, 155e) traversée par une tige conductrice (131) de la structure de support (130).

5. Dispositif selon l'une quelconque des revendications 2 à 4, dans lequel chaque module élémentaire (110) comprend en outre un carter de protection (120) transparent ou translucide placé en vis-à-vis de la carte de circuit imprimé (112) du module, le carter de protection (120) étant fixé sur ledit support de fixation (150) du module.

6. Dispositif selon l'une quelconque des revendications 1 à 5, dans lequel les modules élémentaires (110) sont agencés selon un ou plusieurs étages en forme de prisme, les modules étant disposés sur les faces latérales du prisme.

7. Dispositif selon l'une quelconque des revendications 1 à 5, dans lequel les modules élémentaires (110) sont disposés selon un agencement planaire.

8. Dispositif selon l'une quelconque des revendications 1 à 7, comprenant en outre un circuit électronique d'alimentation et de contrôle (210, 220) connecté à une extrémité de chaque colonne.

9. Dispositif selon la revendication 8, dans lequel le circuit électronique d'alimentation et de contrôle (210, 220) est configuré pour mettre en oeuvre un procédé de diagnostic comprenant une étape de mesure d'une grandeur représentative d'un courant consommé par une colonne et/ou d'une tension aux bornes d'une colonne de modules élémentaires (110).

10. Dispositif selon la revendication 8 ou 9, dans lequel le circuit électronique d'alimentation et de contrôle (210, 220) est configuré pour mettre en oeuvre un procédé de diagnostic comprenant les étapes suivantes :
a) commander un module élémentaire (110) d'une colonne à l'état allumé et mesurer une valeur représentative du courant circulant dans la colonne;
b) commander ledit module élémentaire (110) de ladite colonne à l'état éteint et mesurer une valeur représentative du courant circulant dans la colonne ; et
c) comparer la différence entre la valeur mesurée à l'étape a) et la valeur mesurée à l'étape b) à une valeur nominale de référence (I_{ref-pix}) et, si l'écart entre ladite différence et ladite valeur nominale de référence excède une marge déterminée, en déduire que ledit module élémentaire (110) est défaillant.

11. Dispositif selon l'une quelconque des revendications 1 à 10, comprenant une enveloppe diffusante (190) entourant la structure de support (130) et les modules élémentaires (110).

12. Dispositif selon la revendication 11, dans lequel l'enveloppe diffusante (190) est une enveloppe gonflable.

## Patentansprüche

1. Beleuchtungsvorrichtung , die Folgendes aufweist:
- eine elektrisch leitende Trägerstruktur (130); und
- eine Vielzahl von elementaren Beleuchtungsmodulen (110), die an der Trägerstruktur befestigt ist, wobei jedes elementare Modul eine gedruckte Leiterplatte (112) und, auf der gedruckten Leiterplatte montiert, eine LED-Baugruppe (114) und eine elektronische Schaltung (116) zur Versorgung und Steuerung der LED-Baugruppe (114) aufweist,
wobei in jedem Elementarmodul (110) die gedruckte Leiterplatte (112) des Moduls mindestens einen Referenzanschluss (V-) aufweist, wobei die Referenzanschlüsse (V-) der gedruckten Leiterplatten (112) der verschiedenen Elementarmodule (110) über die Trägerstruktur (130) elektrisch miteinander verbunden sind,
wobei die Elementarmodule (110) in einer Vielzahl von Spalten angeordnet sind, die jeweils eine Vielzahl von Elementarmodulen (110) aufweisen, wobei jedes Modul zwei Anschlüsse (118) für eine Stromversorgung und eine Steuerung aufweist, und wobei die Elementarmodule (110) einer gleichen Spalte über ihre jeweiligen Anschlüsse (118) für eine Stromversorgung und eine Steuerung in einer Reihe verbunden sind.

2. Vorrichtung nach Anspruch 1, wobei jedes Elementarmodul (110) einen Modul-Befestigungsträger (150) zur Befestigung des Moduls an der Trägerstruktur (130) aufweist.

3. Vorrichtung nach Anspruch 2, wobei in jedem Elementarmodul (110) der Modul-Befestigungsträger (150) ein elektrisch leitendes Teil (155) aufweist, das einen Referenzanschluss (V-) der Leiterplatte des Moduls mit der Trägerstruktur (130) elektrisch verbindet.

4. Vorrichtung nach Anspruch 3, wobei das elektrisch leitende Teil (155) einen leitenden Stab (155a) aufweist, der an seinen Enden mit leitenden Laschen (155b, 155c) versehen ist, die jeweils eine Öffnung (155d, 155e) aufweisen, die von einem leitenden Stab (131) der Trägerstruktur (130) durchquert wird.

5. Vorrichtung nach einem der Ansprüche 2 bis 4, wobei jedes Elementarmodul (110) ferner ein transparentes oder durchsichtiges Schutzgehäuse (120) aufweist, das vor der Leiterplatte (112) des Moduls angeordnet ist, wobei das Schutzgehäuse (120) an dem Modul-Befestigungsträger (150) befestigt ist.

6. Vorrichtung nach einem der Ansprüche 1 bis 5, wobei die Elementarmodule (110) in einer oder mehreren prismenförmigen Stufen angeordnet sind, wobei die Module an den Seitenflächen des Prismas angeordnet sind.

7. Vorrichtung nach einem der Ansprüche 1 bis 5, wobei die Elementarmodule (110) gemäß einem planaren Layout angeordnet sind.

8. Vorrichtung nach einem der Ansprüche 1 bis 7, ferner aufweisend eine elektronischen Stromversorgungs- und Steuerschaltung (210, 220), die mit einem Ende jeder Spalte verbunden ist.

9. Vorrichtung nach Anspruch 8, wobei die elektronische Stromversorgungs- und Steuerschaltung (210, 220) konfiguriert ist zum Implementieren eines Diagnoseverfahrens, das einen Schritt der Messung einer Größe aufweist, die für einen von einer Spalte verbrauchten Strom und/oder für eine Spannung über eine Spalte von Elementarmodulen (110) repräsentativ ist.

10. Vorrichtung nach Anspruch 8 oder 9, wobei die elektronische Stromversorgungs- und Steuerschaltung (210, 220) konfiguriert ist zum Implementieren eines Diagnoseverfahrens, das die folgenden Schritte aufweist:
a) Steuern eines Elementarmoduls (110) einer Spalte in den eingeschalteten Zustand und Messen eines Wertes, der für den durch die Spalte fließenden Strom repräsentativ ist;
b) Steuern des Elementarmoduls (110) der Spalte in den Aus-Zustand und Messen eines Wertes, der für den durch die Spalte fließenden Strom repräsentativ ist; und
c) Vergleichen der Differenz zwischen dem im Schritt a) gemessenen Wert und dem im Schritt b) gemessenen Wert mit einem nominalen Referenzwert (Iref-pix) und, wenn der Abstand zwischen dieser Differenz und dem nominalen Referenzwert eine bestimmte Spanne überschreitet, Ableiten daraus, dass das Elementarmodul (110) defekt ist.

11. Vorrichtung nach einem der Ansprüche 1 bis 10, aufweisend eine Streuhülle (190), die die Trägerstruktur (130) und die Elementarmodule (110) umgibt.

12. Vorrichtung nach Anspruch 11, wobei die Streuhülle (190) eine aufblasbare Hülle ist.

## Claims

1. Lighting device comprising:
- an electrically-conductive support structure (130); and
- a plurality of elementary lighting modules (110) fastened to the support structure, each elementary module comprising a printed circuit board (112) and, assembled on the printed circuit board, a LED assembly (114) and an electronic circuit (116) for powering and controlling the LED assembly (114),
wherein, in each elementary module (110), the printed circuit board (112) of the module comprises at least one reference terminal (V-), the reference terminals (V-) of the printed circuit boards (112) of the different elementary modules (110) being electrically connected to one another via the support structure (130), wherein the elementary modules (110) are arranged according to a plurality of columns, each comprising a plurality of elementary modules (110), each module comprising two power supply and control connectors (118), and the elementary modules (110) of a same column being connected in a chain via their respective power supply and control connectors (118).

2. Device according to claim 1, wherein each elementary module (110) comprises a support for fastening (150) the module to the support structure (130).

3. Device according to claim 2, wherein, in each elementary module (110), the module fastening support (150) comprises an electrically-conductive part (155) electrically connecting a reference terminal (V-) of the printed circuit board of the module to the support structure (130).

4. Device according to claim 3, wherein said electrically-conductive part (155) comprises a conductive rod (155a) provided at its ends with conductive tabs (155b, 155c), each comprising an opening (155d, 155e) crossed by a conductive rod (131) of the support structure (130).

5. Device according to any of claims 2 to 4, wherein each elementary module (110) further comprises a transparent or translucent protection casing (120) placed in front of the printed circuit board (112) of the module, the protection casing (120) being fastened to said support for fastening (150) the module.

6. Device according to any of claims 1 to 5, wherein the elementary modules (110) are arranged according to one or a plurality of prism-shaped stages, the modules being arranged on the lateral surfaces of the prism.

7. Device according to any of claims 1 to 5, wherein the elementary modules (110) are arranged according to a planar layout.

8. Device according to any of claims 1 to 7, further comprising an electronic power supply and control circuit (210, 220) connected to an end of each column.

9. Device according to claim 8, wherein the electronic power supply and control circuit (210, 220) is configured to implement a diagnosis method comprising a step of measurement of a quantity representative of a current consumed by a column and/or of a voltage across a column of elementary modules (110).

10. Device according to claim 8 or 9, wherein the electronic power supply and control circuit (210, 220) is configured to implement a diagnosis method comprising the following steps:
a) controlling an elementary module (110) of a column to the on state and measuring a value representative of the current flowing through the column;
b) controlling said elementary module (110) of said column in the off state and measuring a value representative of the column flowing through the column; and
c) comparing the difference between the value measured at step a) and the value measured at step b) with a nominal reference value (I_{ref-pix}) and, if the interval between said difference and said nominal reference value exceeds a determined margin, deducing therefrom that said elementary module (110) is defective.

11. Device according to any of claims 1 to 10, comprising a diffusing envelope (190) surrounding the support structure (130) and the elementary modules (110).

12. Device according to claim 11, wherein the diffusing envelope (190) is an inflatable envelope.
